# EUROPEAN PATENT APPLICATION

(11) **EP 4 582 997 A1**
(43) Date of publication of application: **09.07.2025**
(21) Application number: 23869770.0
(22) Date of filing: 26.06.2023
(51) Int. Cl.: G06F 30/32, H03K 3/037

(54) **CIRCUIT STRUCTURE AND PROCESSOR**

(30) Priority: 26.09.2022 CN 202211175696
(71) Applicant: Huawei Technologies Co., Ltd., Shenzhen, Guangdong 518129 (CN)
(72) Inventor: LU, Jinlei, Shenzhen, Guangdong 518129 (CN); HU, Di, Shenzhen, Guangdong 518129 (CN); ROSEN, Eitan, Shenzhen, Guangdong 518129 (CN); KANG, Jian, Shenzhen, Guangdong 518129 (CN)
(74) Representative: Goddar, Heinz J.
(86) International application number: PCT/CN2023/102315
(87) International publication number: WO 2024/066522

(57) **Abstract**

This application provides a circuit structure and a processor. The circuit structure includes a selector and a register. The selector includes a plurality of input ends, an output end, and a control end. A first input end in the plurality of input ends is configured to input a data signal, a second input end in the plurality of input ends is coupled to an output end of the register, and the output end of the selector is coupled to an input end of the register. The selector selectively transmits, to the output end of the selector based on a control signal input by the control end, a data signal input by the first input end or the data signal stored in the register. According to the circuit structure provided in this application, a data transmission delay can be reduced, so that a data transmission rate is improved.

## Description

This application claims priority to Chinese Patent Application No. 202211175696.2, filed with the China National Intellectual Property Administration on Monday, September 26, 2022 and entitled "CIRCUIT STRUCTURE AND PROCESSOR", which is incorporated herein by reference in its entirety.

### TECHNICAL FIELD

Embodiments of this application relate to the field of integrated circuits, and in particular, to a circuit structure and a processor.

### BACKGROUND

With development of science and technology, electronic information technologies are rapidly improved, and a data amount of instructions that need to be processed by a processor significantly increases. A pipeline design (to be specific, instructions are decomposed into a plurality of steps, and operations of steps of different instructions overlap, so that several instructions are processed in parallel, to accelerate a program running process) of the processor improves a data throughput of the processor. In the pipeline design and a physical implementation of the processor, one or more levels of registers are usually disposed in a running pipeline, to reduce a logical depth of each level of pipeline. This can improve performance of the processor. However, introduction of the register causes a delay to a data transmission path. In addition, during physical implementation of the pipeline, a specific time margin needs to be reserved for the register. The time margin also causes a data transmission delay.

Therefore, how to reduce a delay caused by a register in pipeline work of a processor to further improve a data transmission rate of the processor becomes a problem that needs to be resolved.

### SUMMARY

This application provides a circuit structure and a processor, so that a delay caused by a register can be reduced. To achieve the foregoing objective, the following technical solutions are used in this application.

To achieve the foregoing objective, the following technical solutions are used in this application.

According to a first aspect, an embodiment of this application provides a circuit structure. The circuit structure includes a selector and a register. The selector includes a plurality of input ends, an output end, and a control end. A first input end in the plurality of input ends is configured to input a data signal, a second input end in the plurality of input ends is coupled to an output end of the register, and the output end of the selector is coupled to an input end of the register. The selector selectively transmits, to the output end of the selector based on a control signal input by the control end, a data signal input by the first input end or the data signal stored in the register.

According to the circuit structure provided in embodiments of this application, the selector is disposed on a data transmission path, the input end of the register is connected to the output end of the selector, and the output end of the register is connected to one of input ends of the selector. In this way, the register may be bypassed, the data signal may be directly output via the other input end of the selector, and the register may further latch the data signal. The register in embodiments of this application is bypassed, that is, there is no delay caused by the data signal passing through the register in a signal transmission path, there is no data transmission delay caused by clock uncertainty, and a margin of the register that is reserved for the OCV does not need to be considered. Therefore, compared with that in the conventional technology, the circuit structure provided in embodiments of this application can reduce a data signal transmission delay, thereby improving a data transmission rate.

In a possible implementation, the register further includes a clock signal end, configured to input a clock signal. The circuit structure further includes a signal generator, where the signal generator is configured to generate the control signal and the clock signal.

In a possible implementation, the circuit structure further includes a pulse signal generator. An input end of the pulse signal generator is coupled to the signal generator, and an output end is coupled to the control end of the selector. The pulse signal generator includes a NAND gate and at least one buffer. A first input end of the NAND gate is coupled to the signal generator, the first input end of the NAND gate is coupled to a second input end of the NAND gate via the at least one buffer, and an output end of the NAND gate is coupled to the control end of the selector.

In a possible implementation, the circuit structure further includes at least one buffer or at least one inverter. The output end of the NAND gate is coupled to the clock signal end of the register via the at least one buffer or the at least one inverter.

In a possible implementation, the data signal is latched in the register before the selector switches from being coupled between the first input end and the output end to being coupled between the second input end and the output end.

In a possible implementation, the register further includes the clock signal end, where the clock signal end is configured to input the clock signal. The control signal includes a first level signal and a second level signal. The first level signal is used to control the first input end of the selector to be coupled to the output end, and the second level signal is used to control the second input end of the selector to be coupled to the output end. A rising edge of the clock signal is later than a starting edge of the first level signal for first preset duration, and the first preset duration includes a sum of duration of the data signal transmitted from the first input end to the output end of the selector, a data signal transmission delay caused by a wire from the first input end to the output end in the selector, and setup time of the register.

In a possible implementation, a cut-off edge of the first level signal is later than the rising edge of the clock signal for second preset duration, and the second preset duration includes a sum of duration of the data signal transmitted from the input end to the output end of the register, a data signal transmission delay caused by a wire from the input end to the output end in the register, and a pulse width margin.

According to a second aspect, an embodiment of this application provides a processor. The processor includes a pipeline structure, and the pipeline structure includes the circuit structure according to the first aspect.

In a possible implementation, the register in the circuit structure is a first register, and the pipeline structure further includes a second register and a third register. An output end of the second register is coupled to the first input end of the selector, to input the data signal to the first input end of the selector; and the output end of the selector is coupled to an input end of the third register, to output the data signal to the third register.

In a possible implementation, the processor further includes a first clock generator and a second clock generator, the first clock generator is configured to transmit a first clock signal to the second register, and the second clock generator is configured to transmit a third clock signal to the third register.

It should be understood that technical solutions in the second aspect of this application are consistent with those in the first aspect of this application, and beneficial effects achieved by the aspects and the corresponding feasible implementations are similar. Details are not described.

### BRIEF DESCRIPTION OF DRAWINGS

To describe the technical solutions in embodiments of this application more clearly, the following briefly introduces the accompanying drawings used for describing embodiments of this application. Apparently, the accompanying drawings in the following description show merely some embodiments of this application, and a person of ordinary skill in the art may still derive other drawings from these accompanying drawings without creative efforts.
FIG. 1A is a schematic of a structure of a register used in a pipeline in a processor in a conventional technology;
FIG. 1B shows a clock signal for driving the register shown in FIG. 1A;
FIG. 2 is a schematic of a circuit structure according to an embodiment of this application;
FIG. 3 is a timing schematic of driving the circuit structure shown in FIG. 2 to work according to an embodiment of this application;
FIG. 4 is a schematic of a structure of a processor according to an embodiment of this application;
FIG. 5 is a timing schematic of driving a pipeline in the processor shown in FIG. 4 to work according to an embodiment of this application; and
FIG. 6 is a schematic of a structure of a pulse signal generator according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The "first", the "second", and similar terms mentioned herein do not indicate any order, quantity or significance, but are used to only distinguish different components. Similarly, similar words such as "a" or "an" do not imply a quantitative limit, but rather the existence of at least one.

In embodiments of this application, the terms such as "example" or "for example" are used to represent an example, an illustration, or a description. Any embodiment or design scheme described as an "example" or "for example" in embodiments of this application shall not be explained as being more preferred or having more advantages than another embodiment or design scheme. To be precise, the word such as "example" or "for example" is intended to present a related concept in a specific manner. In the descriptions of embodiments of this application, unless otherwise specified, "a plurality of" means two or more.

In the conventional technology, in a pipeline design and a physical implementation of the processor, one or more levels of registers are usually disposed in a running pipeline, to reduce a logical depth of each level of pipeline. This can improve performance of the processor. However, introduction of the register causes a delay to a data transmission path. In addition, during physical implementation of the pipeline, a specific time margin needs to be reserved for the register. The time margin also causes a data transmission delay.

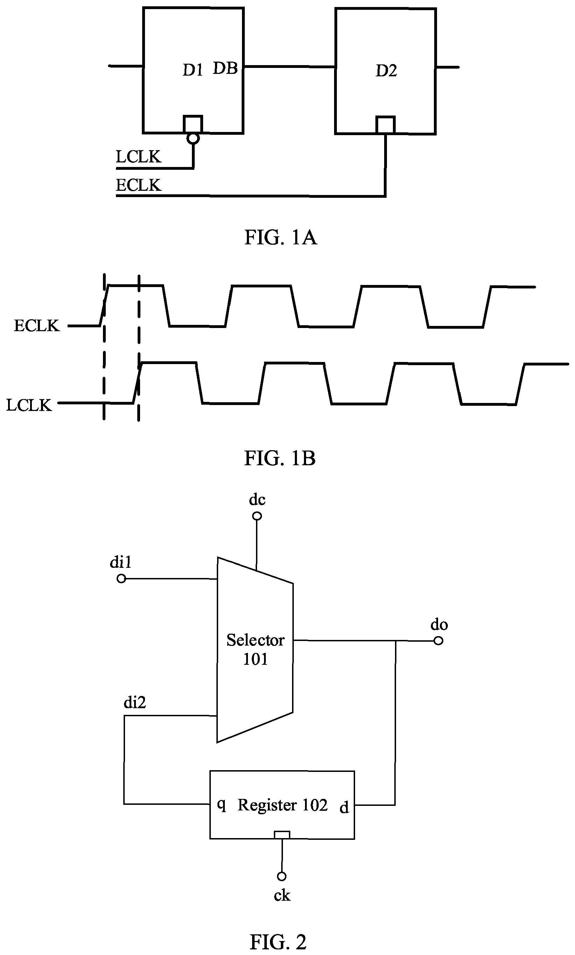

In view of this, the industry proposes a structure of a register shown in FIG. 1. FIG. 1A is a schematic of a structure of a register used in a pipeline in a processor according to a conventional technology. The register shown in FIG. 1A is a soft edge flip-flop (soft edge flip-flop), the soft edge flip-flop includes two cascaded latches D1 and D2, and a data output end DB of the previous latch D1 is an input end of the latch D2. In addition, a clock signal end LCLK of the latch D1 and a clock signal end ECLK of the latch D2 input different clock signals, and the clock signals input by the clock signal end LCLK of the latch D1 and the clock signal end ECLK of the latch D2 are shown in FIG. 1B. It can be learned from FIG. 1A that phases of open time of the latch D1 and open time of the latch D2 are inverse. For example, when a signal input by the clock signal end LCLK of the latch D1 is a low-level signal, the latch D1 is open. When a signal input by the clock signal end ECLK of the latch D2 is a high-level signal, the latch D2 is open. However, in a timing shown in FIG. 1B, the open time of the latch D1 and the open time of the latch D2 have a specific overlapping area. In other words, when the latch D1 is not closed, the latch D2 is open. Therefore, when a data signal passes through the register, a data transmission delay caused by a clock uncertainty (that is, a deviation between ideal arrival time and time at which a clock edge actually arrives at a pin of the register) can be reduced.

In the conventional technology described above, the data transmission delay caused by the clock uncertainty can be reduced. However, because the latch D1 and the latch D2 are still disposed in the pipeline in the processor, there is still a specific delay when the data signal passes through the latch D1 and the latch D2. In addition, during actual application, an on-chip variation (OCV, On-chip variation) caused by the introduction of the register further needs to be considered, and a margin is reserved. However, in the conventional technology described above, because there is always the register on the data transmission path, the margin reserved for the OCV cannot be eliminated. In conclusion, the conventional technology still fails to resolve the data transmission delay caused by the introduction of the register.

According to a circuit structure provided in embodiments of this application, a selector is disposed on a data transmission path, an input end of a register is connected to an output end of the selector, and an output end of the register is connected to one of input ends of the selector. In this way, the register may be bypassed, a data signal may be directly output via the other input end of the selector, and the register may further latch the data signal. The register in embodiments of this application is bypassed, in other words, there is no delay caused by the data signal passing through the register in a signal transmission path, there is no data transmission delay caused by clock uncertainty, and a margin of the register that is reserved for the OCV does not need to be considered. Therefore, compared with that in the conventional technology, the circuit structure provided in embodiments of this application can reduce a data signal transmission delay, thereby improving a data transmission rate. The following describes this application in more detail with reference to the embodiments shown in FIG. 2 to FIG. 6.

It should be noted that the circuit structure provided in this embodiment of this application may be applied to a circuit or a device that uses a timing device like a register or a latch to implement a pipeline design. The device may include, for example, various types of processors, including but not limited to a central processing unit (Central Processing Unit, CPU), a graphics processing unit (Graphics Processing Unit, GPU), and an artificial intelligence processor, for example, a neural-network processing unit (Network Processing Unit, NPU). In addition, the circuit structure provided in embodiments of this application may be further applied to a device like a programmable logic device (PLD, Programmable Logic Device). In addition, the register or the latch provided in embodiments of this application may be various types of registers or latches, including but not limited to a D latch, a JK latch, an R-S latch, a soft edge flip-flop, or the like. This is not specifically limited in embodiments of this application.

FIG. 2 is a schematic of a circuit structure 100 according to an embodiment of this application. As shown in FIG. 2, the circuit structure 100 includes a selector 101 and a register 102. The selector 101 includes an input end di1, an input end di2, and an output end do. The input end di1 of the selector 101 is configured to input a data signal, the output end do of the selector 101 is coupled to an input end d of the register 102, and an output end q of the register 102 is coupled to the input end di2 of the selector 101. The selector 101 is further provided with a control end dc, where the control end dc is configured to input a control signal. The control signal is used to control one of the input end di1 and the input end di2 of the selector 101 to be coupled to the output end do, to transmit, to the output end do of the selector 101, a data signal input by the input end di1 or the signal latched by the register 102. The register 102 is further provided with a clock signal end ck. The clock signal end ck is configured to input a clock signal. Based on control of the clock signal end ck, the register 102 latches a signal input by the input end d (namely, a signal output by the output end do of the selector 101) or remains the latched signal unchanged.

In this embodiment of this application, a first clock signal input by the clock signal end ck of the register 102 is obtained by delaying, for preset duration, a first control signal input by the control end dc of the selector 101, the first clock signal is used to control the input end d of the register 102 to input a data signal, and the first control signal is used to control the selector 101 to couple the input end di1 to the output end do. In addition, the preset duration is less than a pulse width for controlling the input end di1 of the selector 101 to be coupled to the output end do. In a possible implementation, when the register 102 is a D latch, the clock signal input by the clock signal end ck of the register 102 is obtained after the control signal input by the control end dc of the selector 101 is inverted and delayed for the preset duration. That is, in this embodiment of this application, before the selector 101 switches from being coupled between the input end di1 and the output end do to being coupled between the input end di2 and the output end do, the data signal is latched in the register 102. In addition, the control signal input by the control end of the selector 101 may include a first level signal and a second level signal. The first level signal is used to control the input end di1 of the selector 101 to be coupled to the output end do, and the second level signal is used to control the input end di2 of the selector 101 to be coupled to the output end do. A rising edge of the clock signal input by the clock signal end ck of the register 102 is later than a starting edge of the first level signal for first preset duration. The first preset duration includes a sum of duration of the data signal transmitted from the input end di1 to the output end do of the selector 101, a data signal transmission delay caused by a wire from the input end di1 to the output end do in the selector 101, and setup time of the register 102. In addition, a cut-off edge of the first level signal is later than the rising edge of the clock signal for second preset duration. The second preset duration includes a sum of duration of the data signal transmitted from the input end d to the output end q of the register 102, a data signal transmission delay caused by a wire from the input end d to the output end q in the register 102, and a pulse width margin.

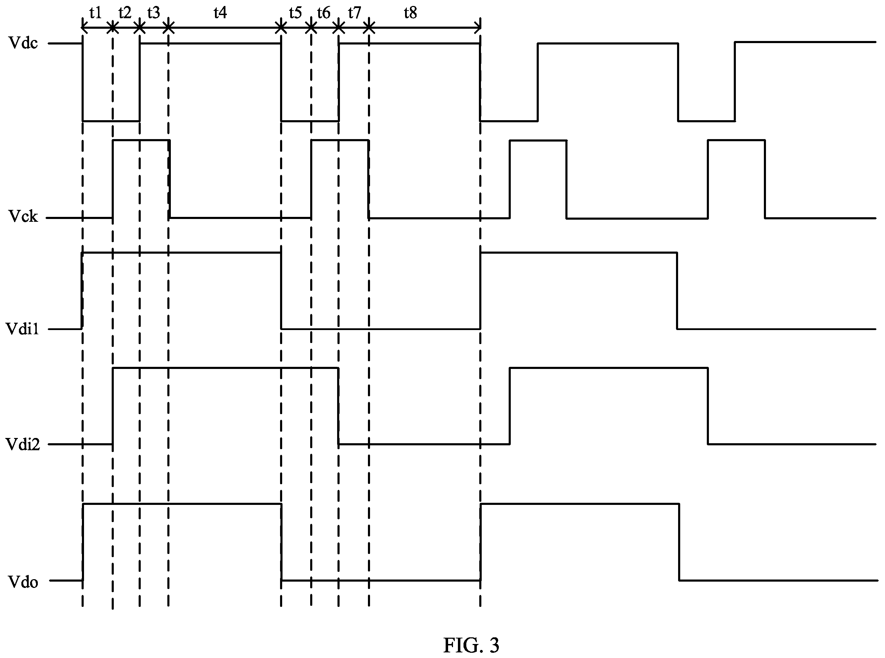

The following describes in detail a working principle of the circuit structure 100 shown in FIG. 2 with reference to a timing shown in FIG. 3 by using an example in which the register 102 is a D latch. It is assumed that when the control end dc of the selector 101 inputs a low-level signal, the input end di1 of the selector 101 is coupled to the output end do; or when the control end dc of the selector 101 inputs a high-level signal, the input end di2 of the selector 101 is coupled to the output end do. In FIG. 3, a signal Vdc is the control signal input by the control end dc of the selector 101, a signal Vck is the clock signal input by the clock signal end of the register 102, a signal Vdi1 is the data signal input by the input end di1 of the selector 101, a signal Vdi2 is a signal input by the input end di2 of the selector 101 (namely, a signal output by the output end q of the register 102), and a signal Vdo is the signal output by the output end do of the selector 101. It should be further noted that the D latch is triggered at the rising edge, in other words, when the clock signal end of the D latch jumps from a low-level signal to a high-level signal, a signal of an output end of the D latch is the same as a signal of an input end of the D latch; or when the clock signal end of the D latch jumps from a high-level signal to a low-level signal, a state of a signal of an output end of the D latch remains unchanged compared with a previous state of the signal.

As shown in FIG. 3, in a time period t1, the control end dc of the selector 101 inputs a low-level signal, the input end di1 of the selector 101 is coupled to the output end do, and the data signal Vdi1 input by the input end di1 of the selector 101 is the high-level signal shown in FIG. 3. That is, the high-level signal input by the input end di1 is transmitted to the output end do. In this time period, a state of the register 102 remains unchanged compared with that in a previous period, and a state of the signal output by the output end q of the register 102 (namely, the signal input by the input end di2 of the selector 101) remains unchanged compared with that in a previous period.

In a time period t2, a high-level signal of the control end dc of the selector 101 remains unchanged, the input end di1 of the selector 101 is coupled to the output end do, and the output end do of the selector 101 outputs the high-level signal. The clock signal end ck of the register 102 jumps from a low level to a high level. In this time period, the register 102 latches the signal input by the input end d (namely, the signal output by the output end do of the selector 101), in other words, latches the high-level signal input by the input end di1. The signal output by the output end q of the register 102 (namely, the signal input by the input end di2 of the selector 101) is the latched high-level signal.

In a time period t3, the control end dc of the selector 101 inputs a high-level signal, the input end di2 of the selector 101 is coupled to the output end do, and the high-level signal of the clock signal end ck of the register 102 remains unchanged. In this time period, the high-level signal latched by the register 102 remains unchanged, and the output end q of the register 102 transmits the latched high-level signal to the output end do of the selector 101 via the input end di2 of the selector 101.

In a time period t4, the control end dc of the selector 101 inputs a high-level signal, the input end di2 of the selector 101 is coupled to the output end do, and the clock signal end ck of the register 102 jumps from the high-level signal to the low-level signal. In this time period, regardless of how the input end d of the register 102 changes, the latched high-level signal of the output end q of the register 102 in the previous time period t3 remains unchanged, and the high-level signal output by the output end q of the register 102 is transmitted to the output end do of the selector 101 via the input end di2 of the selector 101.

It can be learned from the time period t1 to the time period t4 that, in the time period t1 to the time period t4, the signal output by the output end do of the selector 101 is always the high-level signal, that is, the signal output by the output end do of the selector 101 is the same as the data signal input by the input end di1 of the selector 101. In addition, it can be learned from the time period t1 to the time period t4 that the data signal is latched in the register 102 before the selector 101 switches from being coupled between the input end di1 and the output end do to being coupled between the input end di2 and the output end do. In addition, the control signal input by the control end of the selector 101 includes the high-level signal and the low-level signal shown in FIG. 3. The high-level signal is used to control the input end di1 of the selector 101 to be coupled to the output end do, and the low-level signal is used to control the input end di2 of the selector 101 to be coupled to the output end do. It can be learned from FIG. 3 that a rising edge of the clock signal Vck input by the clock signal end ck of the register 102 is later than a starting edge (namely, a falling edge in FIG. 3) of the low-level signal in the control signal Vdc for first preset duration. The first preset duration includes a sum of duration of the data signal transmitted from the input end di1 to the output end do of the selector 101, a data signal transmission delay caused by a wire from the input end di1 to the output end do in the selector 101, and setup time of the register 102. In addition, a cut-off edge (namely, a rising edge in FIG. 3) of the low-level signal in the control signal Vdc is later than the rising edge of the clock signal Vck for second preset duration. The second preset duration includes a sum of duration of the data signal transmitted from the input end d to the output end q of the register 102, a data signal transmission delay caused by a wire from the input end d to the output end q in the register 102, and a pulse width margin.

Still refer to FIG. 3. In a time period t5, the control end dc of the selector 101 jumps from the high-level signal to the low-level signal, the input end di1 of the selector 101 is coupled to the output end do, and the data signal Vdi1 input by the input end di1 of the selector 101 is the low-level signal shown in FIG. 3. That is, the low-level signal input by the input end di1 is transmitted to the output end do. In this time period, a state of the signal of the output end q of the register 102 (namely, the signal input by the input end di2 of the selector 101) in the time period t4 remains unchanged, and the signal is the high-level signal.

In a time period t6, the low-level signal of the control end dc of the selector 101 remains unchanged, the input end di1 of the selector 101 is coupled to the output end do, and the output end do of the selector 101 outputs the low-level signal. The clock signal end ck of the register 102 jumps from the low level to the high level. In this time period, the register 102 latches the signal input by the input end d (namely, the signal output by the output end do of the selector 101), that is, latches the low-level signal input by the input end di1. The signal output by the output end q of the register 102 (namely, the signal input by the input end di2 of the selector 101) is the latched low-level signal.

In a time period t7, the control end dc of the selector 101 jumps from the low-level signal to the high-level signal, the input end di2 of the selector 101 is coupled to the output end do, and the high-level signal of the clock signal end ck of the register 102 remains unchanged. In this time period, the low-level signal latched by the register 102 remains unchanged, and the output end q of the register 102 transmits the latched low-level signal to the output end do of the selector 101 via the input end di2 of the selector 101.

In a time period t8, the high-level signal of the control end dc of the selector 101 remains unchanged, the input end di2 of the selector 101 is coupled to the output end do, and the clock signal end ck of the register 102 jumps from the high-level signal to the low-level signal. In this time period, regardless of how the input end d of the register 102 changes, the latched low-level signal of the output end q of the register 102 in the previous time period t7 remains unchanged, and the low-level signal output by the output end q of the register 102 is transmitted to the output end do of the selector 101 via the input end di2 of the selector 101.

It can be learned from the time period t5 to the time period t8 that, in the time period t5 to the time period t8, the signal output by the output end do of the selector 101 is always the low-level signal, that is, the signal output by the output end do of the selector 101 is the same as the data signal input by the input end di1 of the selector 101.

It can be learned from the circuit structure shown in FIG. 2 and the timing shown in FIG. 3 that, in this embodiment of this application, the register 102 is disposed between the output end do and the input end di2 of the selector 101, and a connection between the input end and the output end of the selector 101 is controlled. In this way, the data signal input by the input end di1 is transmitted to the output end do in a first time period, the register 101 is controlled to open to transmit, to the latch, the data signal input by the input end di1, and the data signal latched by the register 101 is transmitted to the output end do in a second time period. That is, the data signal is output at the output end do of the selector 101 regardless of whether the latch is disabled in the first time period or enabled in the second time period. In this way, the first time period may compensate for a data signal transmission delay caused by working of the register 102, a data signal transmission delay caused by clock uncertainty of the latch, and a data signal transmission delay caused by a margin of the register that is reserved for the OCV. Therefore, compared with the conventional technology, the circuit structure provided in embodiments of this application can reduce a transmission delay in a case in which the data signal passes through the register, thereby improving a data transmission rate.

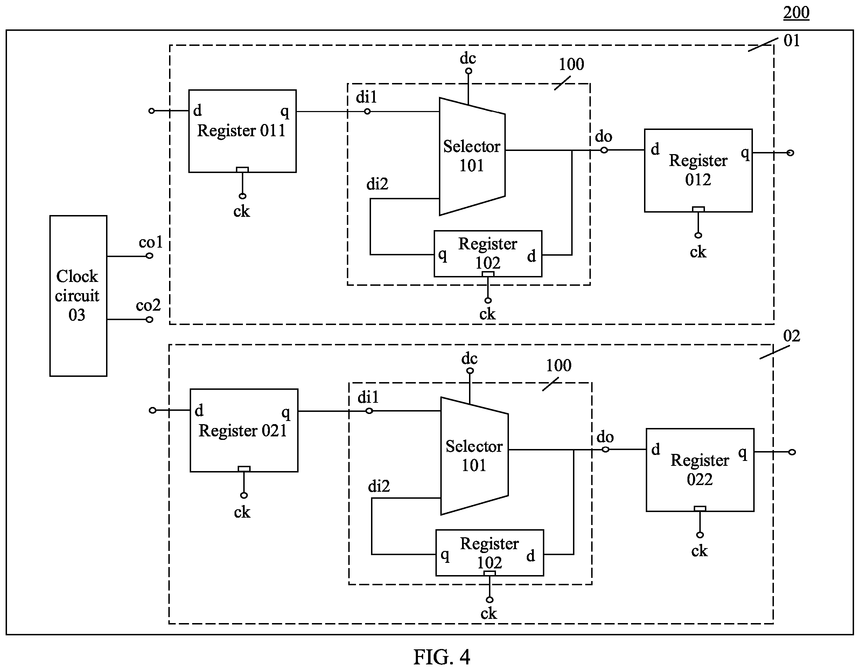

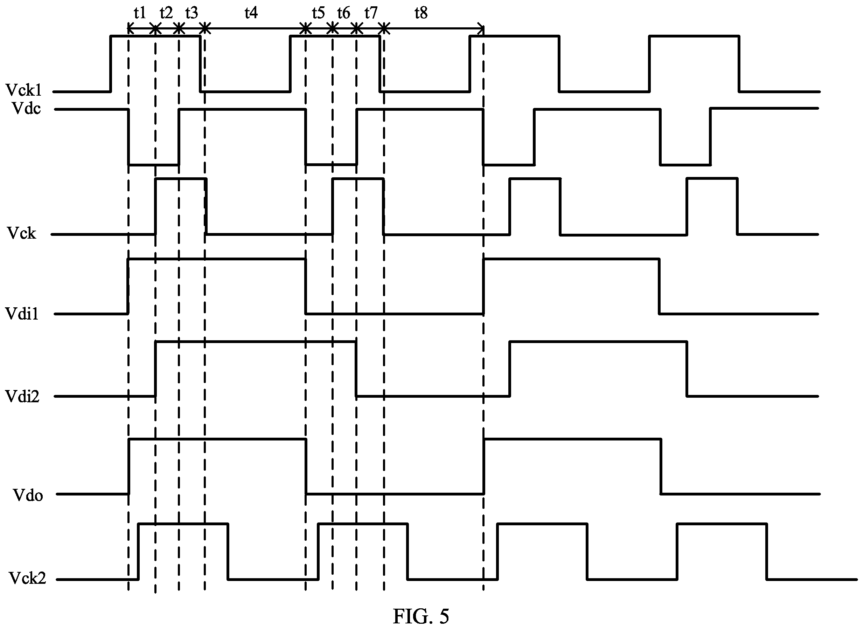

The circuit structure 100 shown in embodiments of this application may be applied to a processor. More specifically, at least one pipeline used for task processing may be disposed in the processor, and each of the at least one pipeline used for task processing includes a plurality of levels of cascaded registers. The circuit structure 100 shown in FIG. 1 may be disposed between any two levels of registers. As shown in FIG. 4, FIG. 4 shows an example in which a processor 200 includes two pipelines 01 and 02. The pipeline 01 includes a register 011 and a register 012 that are cascaded, and the circuit structure 100 shown in FIG. 1 is disposed between the register 011 and the register 012. The pipeline 02 includes a register 021 and a register 022, and the circuit structure 100 shown in FIG. 1 is disposed between the register 021 and the register 022. It should be noted that the processor 200 may include more or fewer pipelines, and each pipeline may include more or fewer registers. This is not specifically limited in embodiments of this application. The following uses the pipeline 01 as an example for more detailed description. As shown in FIG. 4, an output end of the register 011 is coupled to the input end di1 of the selector 101 in the circuit structure 100, and the output end do of the selector 101 is coupled to an input end of the register 012. The register 011 transmits a data signal to the input end di1 of the selector 101 based on control of a clock signal end ck of the register 011, and the selector transmits, to the register 012, the data signal received by the input end di1 and the data signal stored in the register 102. In this embodiment of this application, when both the register 011 and the register 012 are D latches, based on the time sequence shown in FIG. 3, a clock signal input by the clock signal end ck of the register 011 and a clock signal input by a clock signal end ck of the register 012 are shown in FIG. 5. In FIG. 5, Vck1 is the clock signal input by the clock signal end ck of the register 011, and Vck2 is the clock signal input by the clock signal end ck of the register 012. In addition, in this embodiment of this application, a clock cycle of the clock signal Vck1 input by the clock signal end ck of the register 011 is two clock cycles ahead of a clock cycle of the clock signal Vck2 input by the clock signal end ck of the register 022, so that it is ensured that the circuit structure 100 can work normally.

In a conventional processor in which a pipeline is formed by using a plurality of levels of cascaded registers, the output end of the register 011 is directly connected to an input end of the register 102, and an output end of the register 102 is directly connected to an output end of the register 012. As a result, a data signal output by the register 011 can be transmitted to the register 022 only after being delayed by the register 102. In this embodiment of this application, the selector 101 is disposed, so that the data signal output by the register 011 can be directly transmitted to the register 012 in the time period t1 via the selector 101, to compensate for a delay of the register 102 in the conventional technology. This improves a data transmission rate of the pipeline, and further helps improve working efficiency of the processor 200. It should be noted that FIG. 4 shows an example in which the circuit structure 100 shown in FIG. 1 is disposed between the register 011 and the register 022. In another possible implementation, at least one of the register 011 and the register 022 may be replaced with the circuit structure 100 shown in FIG. 1. This is not specifically limited in embodiments of this application.

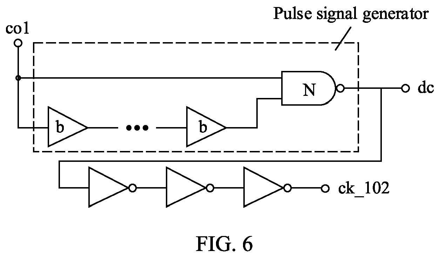

Based on a time sequence shown in FIG. 5, in this embodiment of this application, the processor 200 may be further provided with a clock circuit 03. A clock signal generated by the clock circuit 03 or a clock signal obtained after frequency division is performed on a clock signal generated by the clock circuit 03 is separately transmitted to a clock signal end of each of the foregoing registers. FIG. 4 shows an example of the clock circuit 03. In a possible implementation, a plurality of clock signal generators may be disposed in FIG. 4. For example, three clock signal generators may be disposed for the pipeline 01. One of the three clock signal generators transmits a clock signal Vck1 to the clock signal end ck of the register 011, one of the three clock signal generators transmits a clock signal Vck and a control signal Vdc respectively to the clock signal end ck of the register 102 and the control end dc of the selector 101, and the remaining clock signal generator transmits a clock signal Vck2 to the clock signal end ck of the register 012. In addition, in a possible implementation, the control signal input by the control end dc of the selector 101 may alternatively be generated after the clock signal generated by the clock circuit 03 passes through a pulse signal generator. A structure of the pulse signal generator is shown in FIG. 6. The pulse signal generator includes a plurality of cascaded buffers b and a NAND gate N, where an input end of the plurality of cascaded buffers b is coupled to an output end co1 of the clock circuit 03, an output end of the plurality of cascaded buffers b is coupled to one input end of the NAND gate N, the other input end of the NAND gate N is coupled to the output end co1 of the clock circuit 03, and an output end of the NAND gate N is used as an output end of the pulse signal generator and coupled to the control end dc of the selector 101. In a possible implementation, the control signal input by the control end dc of the selector 101 is generated after the clock signal Vck1 input by the clock signal end ck of the register 011 passes through the pulse signal generator. That is, the output end co1 of the clock circuit 03 separately transmits the output clock signal to the clock signal end ck of the register 101 and the pulse signal generator. The control signal is output to the control end dc of the selector 101 after the output clock signal passes through the pulse signal generator. In addition, in this embodiment of this application, an output end co2 of the clock circuit 03 may transmits the clock signal to the register 012, or the output end co1 of the clock circuit 03 transmits the clock signal to the register 012 via a plurality of levels of buffers.

In a possible implementation of this embodiment of this application, the clock signal input by the clock signal end ck of the register 102 is generated after the control signal output by an output end of the signal generator (namely, the output end of the NAND gate N) is inverted by at least one level of phase inverter, as shown in FIG. 6. In addition, to enable the rising edge of the clock signal input by the clock signal end ck of the register 102 to be located in a middle position of a pulse signal that enables the input end di1 and the output end do of the selector 101 to open, the output end of the signal generator may be connected to the clock signal end ck of the register 102 via an odd quantity of phase inverters. The figure shows the example in which the output end of the signal generator is connected to the clock signal end ck of the register 102 via three phase inverters. It should be noted that a quantity of phase inverters is not specifically limited in embodiments of this application, and is set based on a requirement of an application scenario.

Finally, it should be noted that the foregoing embodiments are merely intended for describing the technical solutions of this application other than limiting this application. Although this application is described in detail with reference to the foregoing embodiments, persons of ordinary skill in the art shall understand that they may still make modifications to the technical solutions described in the foregoing embodiments or make equivalent replacements to some or all technical features thereof, without departing from the scope of the technical solutions of embodiments of this application.

## Claims

1. A circuit structure, comprising a selector and a register, wherein
the selector comprises a plurality of input ends, an output end, and a control end, a first input end in the plurality of input ends is configured to input a data signal, a second input end in the plurality of input ends is coupled to an output end of the register, and the output end of the selector is coupled to an input end of the register; and
the selector selectively transmits, to the output end of the selector based on a control signal input by the control end, a data signal input by the first input end or the data signal stored in the register.

2. The circuit structure according to claim 1, wherein the register further comprises a clock signal end, configured to input a clock signal; and
the circuit structure further comprises a signal generator, wherein the signal generator is configured to generate the control signal and the clock signal.

3. The circuit structure according to claim 2, wherein the circuit structure further comprises a pulse signal generator, an input end of the pulse signal generator is coupled to the signal generator, and an output end is coupled to the control end of the selector; and
the pulse signal generator comprises a NAND gate and at least one buffer, wherein
a first input end of the NAND gate is coupled to the signal generator, the first input end of the NAND gate is coupled to a second input end of the NAND gate via the at least one buffer, and an output end of the NAND gate is coupled to the control end of the selector.

4. The circuit structure according to claim 3, wherein the circuit structure further comprises at least one buffer or at least one inverter; and
the output end of the NAND gate is coupled to the clock signal end of the register via the at least one buffer or the at least one inverter.

5. The circuit structure according to any one of claims 1 to 4, wherein the data signal is latched in the register before the selector switches from being coupled between the first input end and the output end to being coupled between the second input end and the output end.

6. The circuit structure according to claim 5, wherein the control signal comprises a first level signal and a second level signal, the first level signal is used to control the first input end of the selector to be coupled to the output end, and the second level signal is used to control the second input end of the selector to be coupled to the output end, wherein
a rising edge of the clock signal is later than a starting edge of the first level signal for first preset duration, and the first preset duration comprises a sum of duration of the data signal transmitted from the first input end to the output end of the selector, a data signal transmission delay caused by a wire from the first input end to the output end in the selector, and setup time of the register.

7. The circuit structure according to claim 6, wherein a cut-off edge of the first level signal is later than the rising edge of the clock signal for second preset duration, and the second preset duration comprises a sum of duration of the data signal transmitted from the input end to the output end of the register, a data signal transmission delay caused by a wire from the input end to the output end in the register, and a pulse width margin.

8. A processor, wherein the processor comprises a pipeline structure, and the pipeline structure comprises the circuit structure according to any one of claims 1 to 7.

9. The processor according to claim 8, wherein the register in the circuit structure is a first register, and the pipeline structure further comprises a second register and a third register, wherein
an output end of the second register is coupled to the first input end of the selector, to input the data signal to the first input end of the selector; and
the output end of the selector is coupled to an input end of the third register, to output the data signal to the third register.

10. The processor according to claim 9, wherein the processor further comprises a first clock generator and a second clock generator, the first clock generator is configured to transmit a first clock signal to the second register, and the second clock generator is configured to transmit a third clock signal to the third register.
